# DEMANDE DE BREVET EUROPEEN

(11) **EP 1 646 272 A2**
(43) Date de publication de la demande: **12.04.2006**
(21) Numéro de dépôt: 05292067.5
(22) Date de dépôt: 05.10.2005
(51) Int. Cl.: H05K 3/30, H01R 12/36

(54) **Procédé de soudage d'un composant traversant sur une carte à circuit imprimé et relais à souder selon le procédé**

(30) Priorité: 08.10.2004 FR 0410625
(71) Demandeur: Johnson Controls Technology Company, Holland, MI 49423 (US)
(72) Inventeur: Freyermuth, Sébastien, 95520 Osny (FR); Luneau, Olivier, 95430 Auvers sur Oise (FR)
(74) Mandataire: Bloch, Gérard

(57) **Abrégé**

Le relais, destiné à être soudé par refusion sur une carte à circuit imprimé (15) dans laquelle sont ménagés des trous traversants (4), comporte des broches (2) en saillie hors d'un capot (1) et agencées pour s'étendre à travers les trous traversants (4) de la carte. Le relais comporte des moyens (9, 10) de fixation du capot (1) à la carte pour le maintenir dans une position broches (2) en haut. Pour souder le relais sur la carte, on étale de la pâte à braser sur un côté (18) de la carte (15), on retourne la carte (15), on pose le relais (1) tête (3) en haut sur la carte (15) et on l'y fixe, on retourne la carte (15) et on passe la carte dans un four à refusion, avec le composant traversant maintenu tête (3) en bas.

## Description

L'invention concerne les cartes à circuit imprimé portant à la fois des composants CMS (composants montés en surface) et des composants traversants soudés à des pistes du circuit imprimé, les composants traversants étant montés du côté de la carte opposé à celui de ces pistes, leurs broches, ou pattes, selon le composant, traversant la carte par des trous traversants pour rejoindre ces pistes.

L'invention concerne plus particulièrement les cartes utilisées dans les véhicules automobiles, notamment dans les unités de contrôle habitacle ou moteur, qui comportent des composants électroniques, pour la partie intelligente, et des composants électriques, ou de puissance, pour la partie assurant les commandes d'actionneurs. Les composants électroniques, qui sont principalement des circuits logiques, sont pratiquement tous des composants CMS montés sur les pistes du circuit. Quant aux composants électriques, ce sont des composants traversants ; il s'agit de condensateurs, d'inductances, de transistors de puissance et surtout de relais, sans parler des connecteurs.

La demanderesse a toujours cherché à pouvoir souder tous ces composants aux pistes du circuit de la carte dans un four à refusion, les composants traversants étant disposés "tête" en bas, la tête des composants étant opposée à leurs broches (pattes).

En effet, le soudage des composants peut s'effectuer selon les étapes suivantes, après impression des pistes du circuit imprimé sur la carte :
- étalement de la pâte à braser du côté des pistes de la carte,
- retournement de la carte,
- pose des composants traversants, du côté de la carte tournée vers le haut, tête en haut et pattes ou broches en bas,
- retournement de la carte,
- pose des composants CMS, du côté de la carte tourné vers le haut,
- passage au four à refusion, composants traversants tête en bas.
   On remarquera que les composants traversants et les composants CMS sont respectivement implantés des deux côtés de la carte mais soudés en même temps lors de l'unique passage dans le four.
   Les composants traversants sont donc soudés tête en bas, obligeant à les maintenir dans cette position pendant l'étape de passage au four, au moyen d'une pièce supplémentaire les maintenant en appui contre la carte. Il peut s'agir d'une pièce dédiée à cet usage, il peut aussi s'agir du boîtier de protection de la carte agencé à cet effet de façon particulière.
   Mais cette pièce supplémentaire peut risquer d'endommager les composants si son action d'appui ne s'exerce pas au bon endroit. En cas de changement d'implantation des composants, il faut prévoir une nouvelle pièce d'appui de forme différente.
   La demanderesse a donc cherché à s'affranchir de cette pièce supplémentaire sans pour autant renoncer au soudage par refusion de composants traversants sur carte de circuit imprimé. C'est son mérite qui est ici un gage d'activité inventive.
   Ainsi, la présente demande concerne tout d'abord un procédé de soudage d'un composant traversant sur une carte à circuit imprimé, dans lequel
- on étale de la pâte à braser sur un côté de la carte,
- on retourne la carte,
- on pose le composant traversant tête en haut sur la carte et on l'y fixe,
- on retourne la carte et
- on passe la carte dans un four à refusion, avec le composant traversant maintenu tête en bas.
   Au-delà d'une diminution des coûts de fabrication, l'invention offre de surcroît aux constructeurs une grande liberté d'implantation des composants ainsi qu'une souplesse d'évolution de leurs cartes.
   On notera que, contrairement au procédé du document US 5 070 604, dans le procédé de la présente demande, la pose du composant traversant s'effectue directement après le premier retournement et que sa fixation est une fixation sans adhésif, qui ne nécessite donc pas un traitement thermique préalable, même aussi léger soit-il.
   De préférence, on fixe le composant traversant à la carte en l'y clipsant.
   L'invention s'applique surtout aux relais et c'est pourquoi la demanderesse entend également revendiquer un relais agencé pour être soudé par refusion, sans pièce supplémentaire.
   Ainsi, la présente demande concerne également un relais, destiné à être soudé par refusion sur une carte à circuit imprimé dans laquelle sont ménagés des trous traversants, comportant des broches montées en saillie hors d'un capot et agencées pour s'étendre à travers les trous traversants de la carte, relais caractérisé par le fait qu'il comporte des moyens de fixation du capot à la carte pour le maintenir dans une position broches en haut.
   Avantageusement, les moyens de fixation comprennent des moyens de clipsage.
   L'invention est d'autant plus remarquable qu'il était déjà connu, par EP 1 056 159, de ménager, non sur un relais, mais sur un porte-relais des clips d'accrochage sur une carte de circuit imprimé. Bref, avoir voulu souder par refusion sur une carte et directement sans pièce intermédiaire ou supplémentaire des relais a manifestement consisté à surmonter quelques préjugés.
   L'invention sera mieux comprise à l'aide de la description suivante d'une forme de réalisation intéressante du relais de l'invention, en référence au dessin annexé sur lequel
- la figure 1 représente une vue en perspective de dessous d'un capot de relais de l'invention et
- la figure 2 représente une vue de côté du capot de relais de la figure 1 fixé sur une carte de circuit imprimé.

Le relais est monté dans un capot 1, ici de forme générale parallélépipédique représenté broches 2 en l'air, ou en haut, et tête 3 en bas, les portions de broche 2 faisant saillie hors de la base 6 du capot 1.

Deux des arêtes 7, 8 parallèles au broches 2 du capot 1 du relais, n'appartenant pas à une même des quatre faces latérales du capot, donc des arêtes opposées, sont ici prolongées, du même côté que les portions de broche 2 en saillie hors de la base 6, par des clips d'accrochage et de fixation 9, 10.

Chaque clips comporte une jambe tubulaire 11 à laquelle est articulée, près de la base 6 du capot, une tige 12 légèrement pivotante et comportant à son extrémité libre un crochet de clipsage 13. Les clips 9, 10 sont moulés d'une seule pièce avec le capot 1.

Le relais, tel qu'il vient d'être décrit, est destiné à être soudé, dans un four à refusion, sur une carte de circuit imprimé 15, dans laquelle sont ménagés des trous traversants 4 pour les portions de broche 2. Il est ménagé dans la carte 15 d'autres orifices traversants, notamment pour le passage d'ergots de détrompage également sortis du moule avec le capot, et surtout des orifices 16, 17 de réception des clips de fixation 9, 10.

Le soudage du relais s'effectue selon les étapes qui vont maintenant être décrites.

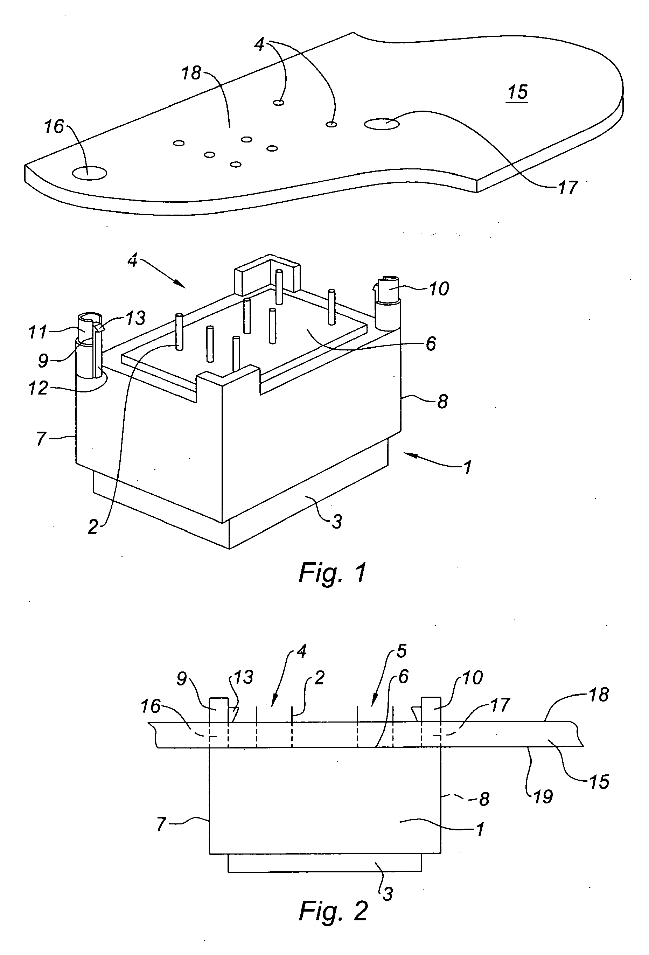

Les pistes du circuit imprimé de la carte 15 sont ici imprimées du côté 18, visible sur la figure 1. On commence par étaler la pâte à braser sur le côté 18 des pistes. Puis on retourne la carte, son côté opposé 19 étant alors tourné vers le haut. On pose ensuite le relais en introduisant les clips 9, 10 à travers les orifices 16, 17 de la carte pour l'y fixer, les clips bloquant la base 6 du capot 1 contre la face 19 de la carte par action des crochets 13 contre la face 18 maintenant le relais avec sa tête 3 en bas (figure 2) et les portions de broche 2, en saillie hors de cette base 6, à travers les orifices traversants 4, tournées vers le haut. Avec le relais, on pose également les autres composants traversants. On retourne à nouveau la carte 15 pour poser les composants CMS sur la face 18 de la carte, tournée vers le haut et, enfin, on passe la carte 15, avec tous ses composants, au four à refusion.

Le soudage du relais dans le four à refusion a été réalisé sans la moindre pièce supplémentaire.

## Revendications

1. Procédé de soudage d'un composant traversant (1) sur une carte à circuit imprimé (15), dans lequel
- on étale de la pâte à braser sur un côté (18) de la carte (15),
- on retourne la carte (15),
- on pose le composant traversant (1) tête (3) en haut sur la carte (15) et on l'y fixe,
- on retourne la carte (15) et
- on passe la carte dans un four à refusion, avec le composant traversant maintenu tête (3) en bas.

2. Procédé de soudage selon la revendication 1, dans lequel on fixe le composant traversant (1) à la carte (15) en l'y clipsant (9, 16, 10, 17).

3. Relais, destiné à être soudé par refusion sur une carte à circuit imprimé (15) dans laquelle sont ménagés des trous traversants (4), comportant des broches (2) montées en saillie hors d'un capot (1) et agencées pour s'étendre à travers les trous traversants (4) de la carte, relais **caractérisé par le fait qu'**il comporte des moyens (9, 10) de fixation du capot (1) à la carte pour le maintenir dans une position broches (2) en haut.

4. Relais selon la revendication 3, dans lequel les moyens de fixation comprennent des moyens de clipsage (9-13).
